# EUROPÄISCHE PATENTANMELDUNG

(11) **EP 4 250 340 A1**
(43) Veröffentlichungstag der Anmeldung: **27.09.2023**
(21) Anmeldenummer: 22164158.2
(22) Anmeldetag: 24.03.2022
(51) Int. Cl.: H01L 21/48, H01L 23/46, H01L 23/373

(54) **VERFAHREN ZUM HERSTELLEN EINER VORRICHTUNG ZUR KÜHLUNG EINER HALBLEITERANORDNUNG MIT EINEM METALLISCHEN KÖRPER**

(71) Anmelder: Siemens Aktiengesellschaft, 80333 München (DE)
(72) Erfinder: Kneißl, Philipp, 90427 Nürnberg (DE); Schwarz, Florian, 90766 Fürth (DE); Danov, Vladimir, 91056 Erlangen (DE); Müller, Volker, 90459 Nürnberg (DE); Neugebauer, Stephan, 91058 Erlangen (DE)
(74) Vertreter: Siemens Patent Attorneys

(57) **Zusammenfassung**

Die Erfindung betrifft ein Verfahren zum Herstellen einer Vorrichtung (2) zur Kühlung einer Halbleiteranordnung. Um ein kostengünstiges und einfaches Herstellungsverfahren anzugeben, welches eine verbesserte Entwärmung der Halbleiteranordnung ermöglicht, werden folgende Schritte vorgeschlagen: Herstellen eines ersten Kühlkanals (20) mittels eines erstens FSC-Verfahrens in einer ersten Tiefe (t1) im metallischen Körper (4), Herstellen eines ersten Verbindungskanals (22) mittels des erstens FSC-Verfahrens, welcher vom ersten Kühlkanal (20) zu einer, insbesondere ebenen, Oberfläche (12) des metallischen Körpers (4) verlaufend angeordnet wird, Herstellen eines zweiten Kühlkanals (24) mittels eines zweiten FSC-Verfahrens in einer zweiten Tiefe (t2) im metallischen Körper (4), wobei die zweite Tiefe (t2) kleiner als die erste Tiefe (t1) ist, wobei über den ersten Verbindungskanal (22) eine fluidtechnische Verbindung zwischen dem ersten Kühlkanal (20) und dem zweiten Kühlkanal (24) hergestellt wird, wobei durch die Kühlkanäle (20, 24) und den ersten Verbindungskanal (22) eine Kühlkanalstruktur (28) ausgebildet wird.

## Beschreibung

Die Erfindung betrifft ein Verfahren zum Herstellen einer Vorrichtung zur Kühlung einer Halbleiteranordnung mit einem metallischen Körper.

Ferner betrifft die Erfindung eine Vorrichtung zur Kühlung einer Halbleiteranordnung.

Überdies betrifft die Erfindung eine Halbleiteranordnung mit mindestens einem Halbleiterelement und einer derartigen Vorrichtung.

Darüber hinaus betrifft die Erfindung einen Stromrichter mit mindestens einer Halbleiteranordnung.

Derartige Vorrichtungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Die Halbleiteranordnungen in einem Stromrichter werden üblicherweise in Form von Leistungshalbleitermodulen realisiert, welche aktuell zumeist mit Schrauben an einen Kühlkörper gepresst werden. Insbesondere bei höheren Leistungen kommen Kühlkörper mit Kühlkanälen, welche ein Wärmetransportmedium, insbesondere ein Kühlfluid, enthalten, zum Einsatz.

Gängige Verfahren zum Herstellen von fluidgekühlten Kühlkörpern mit Kühlkanälen sind Fräsen, Gießen und Umformen, wobei die hergestellten Nuten für die Kühlkanäle zunächst offen sind und erst in einem weiteren Fertigungsschritt verschlossen werden. Zum Verschließen der Nuten wird beispielsweise (Vakuum-)Hartlöten, Laserschweißen oder Verschrauben mit Dichtung eingesetzt. Alternativ können in die Kanäle separat Rohre eingepresst werden, die thermisch und mechanisch an die restliche Kühlplatte angebunden werden. Weitere Möglichkeiten zur Herstellung derartiger Kühlkörper sind Tieflochbohren oder Strangpressprofilen, wobei es erforderlich ist, in einem weiteren Fertigungsschritt die Stirnseiten der Kühlkanäle jeweils zu verschließen und verbinden.

Die Offenlegungsschrift EP 3 823 018 A1 beschreibt ein Elektronikmodul. Das Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Die Offenlegungsschrift US 2006/0108395 A1 beschreibt einen inneren Kanal in einem Metallkörper zur Verwendung bei Anwendungen, bei denen eine innere Flüssigkeitsströmung innerhalb eines Metallkörpers erwünscht ist, wie in einem Wärmetauscher. Der innere Kanal wird in dem Metallkörper durch Reibungsrühren mit einem in den Metallkörper eingetauchten Stift gebildet und der Metallkörper wird mit dem Stift durchquert.

Durch die zunehmende Miniaturisierung der Leistungselektronik in Stromrichtern ergeben sich neue Herausforderungen hinsichtlich der Entwärmung einer Halbleiteranordnung, um eine hohe Zuverlässigkeit bei geringem Platzbedarf, auch unter Berücksichtigung der Herstellungskosten, zu gewährleisten.

Vor diesem Hintergrund besteht die Aufgabe der vorliegenden Erfindung darin, ein kostengünstiges und einfaches Verfahren zum Herstellen einer Vorrichtung zur Kühlung einer Halbleiteranordnung anzugeben, welches eine verbesserte Entwärmung der Halbleiteranordnung ermöglicht.

Diese Aufgabe wird erfindungsgemäß gelöst durch ein Verfahren zum Herstellen einer Vorrichtung zur Kühlung einer Halbleiteranordnung mit einem metallischen Körper umfassend folgende Schritte: Herstellen eines ersten Kühlkanals mittels eines erstens FSC-Verfahrens in einer ersten Tiefe im metallischen Körper, Herstellen eines ersten Verbindungskanals mittels des erstens FSC-Verfahrens, welcher vom ersten Kühlkanal zu einer, insbesondere ebenen, Oberfläche des metallischen Körpers verlaufenden angeordnet wird, Herstellen eines zweiten Kühlkanals mittels eines zweiten FSC-Verfahrens in einer zweiten Tiefe im metallischen Körper, wobei die zweite Tiefe kleiner als die erste Tiefe ist, wobei über den ersten Verbindungskanal eine fluidtechnische Verbindung zwischen dem ersten Kühlkanal und dem zweiten Kühlkanal hergestellt wird, wobei durch die Kühlkanäle und den ersten Verbindungskanal eine Kühlkanalstruktur ausgebildet wird.

Ferner wird die Aufgabe erfindungsgemäß gelöst durch eine Vorrichtung zur Kühlung einer Halbleiteranordnung umfassend: einen metallischen Körper, einen mittels eines erstens FSC-Verfahrens hergestellten ersten Kühlkanal, welcher in einer ersten Tiefe im metallischen Körper verlaufend angeordnet ist, einen mittels des erstens FSC-Verfahrens hergestellten ersten Verbindungskanal, welcher vom ersten Kühlkanal zu einer, insbesondere ebenen, Oberfläche des metallischen Körpers verlaufenden angeordnet ist, einen mittels eines zweiten FSC-Verfahrens hergestellten zweiten Kühlkanal, welcher in einer zweiten Tiefe im metallischen Körper verlaufend angeordnet ist, wobei die zweite Tiefe kleiner als die erste Tiefe ist, wobei der erste Kühlkanal mit dem zweiten Kühlkanal über den ersten Verbindungskanal in einer fluidtechnischen Verbindung steht, wobei durch die Kühlkanäle und den ersten Verbindungskanal eine Kühlkanalstruktur ausgebildet ist.

Überdies wird die Aufgabe erfindungsgemäß gelöst durch eine Halbleiteranordnung mit mindestens einem Halbleiterelement und einer derartigen Vorrichtung, wobei das Halbleiterelement mit der Vorrichtung in einer thermisch leitenden Verbindung steht.

Darüber hinaus wird die Aufgabe erfindungsgemäß gelöst durch einen Stromrichter mit mindestens einer derartigen Halbleiteranordnung.

Der Erfindung liegt die Überlegung zugrunde, die Entwärmung einer Halbleiteranordnung mittels einer Kühlvorrichtung dadurch zu verbessern, dass Kühlkanäle auf mehreren Ebenen angeordnet werden. Die Herstellung der Kühlkanäle in der Vorrichtung wird durch Verwendung von FSC-Verfahren kostengünstig und einfach. Die Kühlvorrichtung umfasst einen metallischen Körper mit einer, insbesondere ebenen, Oberfläche. Der metallische Körper kann zumindest an einer der ebenen Oberfläche abgewandten Seite unter anderem Kühlrippen und/oder Kühlfinnen aufweisen. Durch die im Wesentlichen ebene Oberfläche eines derartigen metallischen Körpers wird das FSC-Verfahren einfacher und kostengünstiger. Der metallischen Körper kann unter anderem quaderförmig ausgeführt sein. Mittels eines erstens FSC-Verfahrens wird in einer ersten Tiefe im metallischen Körper ein erster Kühlkanal hergestellt. Daraufhin wird mittels des erstens FSC-Verfahrens ein erster Verbindungskanal hergestellt, welcher vom ersten Kühlkanal zur, insbesondere ebenen, Oberfläche des metallischen Körpers verlaufenden angeordnet wird. In einem weiteren Schritt wird ein zweiter Kühlkanal mittels eines zweiten FSC-Verfahrens in einer zweiten Tiefe im metallischen Körper hergestellt, wobei die zweite Tiefe kleiner als die erste Tiefe ist. Über den ersten Verbindungskanal wird eine fluidtechnische Verbindung zwischen dem ersten Kühlkanal und dem zweiten Kühlkanal hergestellt. Beispielsweise wird der zweite Kühlkanal derartig angeordnet, dass der erste Verbindungskanal in den zweiten Kühlkanal mündet. Durch die Kühlkanäle und den ersten Verbindungskanal wird eine Kühlkanalstruktur ausgebildet. Das erste FSC-Verfahren und das zweite FSC-Verfahren können sich unter anderem durch zumindest Teile des verwendeten Werkzeugs, z.B. durch die jeweils verwendete rotierende Sonde oder durch den jeweils verwendeten Schweißdorn unterscheiden. Zusätzliche Kühlkanäle in weiteren Tiefen, welche über weitere Verbindungskanäle verbunden sind, sind analog mittels weiterer FSC-Verfahren herstellbar, sodass komplexe innere Verschaltungen, eine parallele Kühlfluidführung, Bypässe und individuelle Kühlkanalstrukturen kostengünstig, einfach und flexibel herstellbar sind.

Durch die FSC-Verfahren sind Kühlkanäle mit einem rechteckigen, insbesondere quadratischen Querschnitt herstellbar, welche insbesondere im Vergleich zu einem runden Querschnitt eine größere Oberfläche damit eine größere Oberfläche aufweisen. Ferner ist eine Kanaloberfläche, insbesondere im Vergleich zu gefrästen Kanälen, rauer, was die Kontaktfläche eines Kühlfluids mit dem metallischen Körper zusätzlich vergrößert und so die Kühlleistung verbessert.

Eine weitere Ausführungsform sieht vor, dass der erste Verbindungskanal im Wesentlichen senkrecht zum ersten Kühlkanal und/oder zur Oberfläche des metallischen Körpers verlaufenden angeordnet wird. Durch eine derartige Anordnung wird das FSC-Verfahren, insbesondere bei einer ebenen Oberfläche des metallischen Körpers einfach und kostengünstig.

Eine weitere Ausführungsform sieht vor, dass der erste Kühlkanal und/oder der zweite Kühlkanal im Wesentlichen parallel zur Oberfläche des metallischen Körpers angeordnet werden. Durch eine derartige parallele Anordnung wird ein gleichmäßiger Wärmeabtransport gewährleistet.

Eine weitere Ausführungsform sieht vor, dass das Herstellen des ersten Kühlkanals mittels eines Werkzeugs mit einem ersten Schweißdorn und das Herstellen des zweiten Kühlkanals mittels eines Werkzeugs mit einem zweiten Schweißdorn erfolgt, wobei der erste Schweißdorn länger als der zweite Schweißdorn ist. Die Tiefe des jeweiligen Kanals wird durch die Länge des verwendeten Schweißdorns, die beispielsweise ab der Schulter des Werkzeugs gemessen wird, bestimmt. Das Herstellen der Kanäle kann dabei mittels unterschiedlicher Werkzeuge, welche unterschiedlich lange Schweißdorne aufweisen, erfolgen, was eine schnelle Herstellung ermöglicht. Alternativ kann das Herstellen der Kanäle mit demselben Werkzeug erfolgen, bei dem der Schweißdorn zum Herstellen des jeweiligen Kanals gewechselt wird, was die Werkzeugkosten reduziert. Durch derartig ausgeführte Schweißdorne wird gewährleistet, dass die durch das jeweilige FSC-Verfahren hergestellten Kanäle bündig zur Oberfläche verschlossen werden.

Eine weitere Ausführungsform sieht vor, dass eine Kanalhöhe eines Kühlkanals durch Variieren einer Drehzahl eines Werkzeugs und/oder durch Variieren einer Verfahrgeschwindigkeit eines Werkzeugs verändert wird. Die Material-Förderrate ist unter anderem abhängig von der Werkzeuggeometrie, der Drehzahl, der Verfahrgeschwindigkeit und der Plastifizierung des Material. Wenn an einer Stelle mehr Material abtransportiert wird, wird ein Kanal an dieser Stelle höher, sodass die Kanalhöhe durch Variieren der Drehzahl und/oder durch Variieren der Verfahrgeschwindigkeit einfach und kostengünstig veränderbar ist. Insbesondere durch graduelle Veränderung derartiger Prozessparameter ist beispielsweise eine Kontur im Bereich einer Kanaldecke herstellbar.

Eine weitere Ausführungsform sieht vor, dass eine Kanalbreite des ersten Verbindungskanals durch einen graduellen Abfall und/oder Anstieg einer Drehzahl und/oder Verfahrgeschwindigkeit eines Werkzeugs verändert wird. Auf diese Weise ist beispielsweise ein sich verjüngender Verbindungskanal einfach und kostengünstig herstellbar.

Eine weitere Ausführungsform sieht vor, dass zumindest einer der Kühlkanäle mäanderförmig verlaufend angeordnet wird. Eine mäanderförmige Kühlkanalstruktur ist mittels des FSC-Verfahrens großflächig in einem Prozessschritt und damit einfach und kostengünstig herstellbar und ermöglicht eine effiziente Entwärmung und Wärmespreizung.

Eine weitere Ausführungsform sieht vor, dass Verfahren folgende weitere Schritte umfasst: Herstellen eines Zuführungskanals mittels des zweiten FSC-Verfahrens, welcher vom zweiten Kühlkanal zu einer Oberfläche des metallischen Körpers verlaufend angeordnet wird, Befüllen der Kühlkanalstruktur über den Zuführungskanal mit einem Wärmetransportfluid und Verschließen des Zuführungskanals. Ein derartiges Wärmetransportfluid kann elektrisch leitfähig und elektrisch nicht-leitfähig ausgeführt sein. Unter anderem kommen Luft, insbesondere deionisiertes, Wasser, eine Wasser-Glykol-Gemisch, dielektrische Flüssigkeiten und/oder Öle infrage. Beispielsweise ein Abdichtstopfen kann den Zuführungskanal nach dem Befüllen, insbesondere fluiddicht, lösbar verschließen. Ein derartiger Zuführungskanal entsteht während des zweiten FSC-Verfahrens üblicherweise als Nebenprodukt. Durch die Nutzung des Zuführungskanals zur Befüllung mit einem Wärmetransportfluid wird der Herstellungsprozess weiter vereinfacht und die Herstellungskosten werden durch Reduzierung der Fertigungsschritte weiter gesenkt.

Eine weitere Ausführungsform sieht vor, dass die Kühlkanalstruktur mit dem Wärmetransportfluid für eine Zweiphasenkühlung konfiguriert ist. Beispiele für eine Zweiphasenkühlungen sind unter anderem ein Thermosiphon, eine Heatpipe oder eine pulsierende Heatpipe. Insbesondere ist Perfluor-N-alkylmorpholin aufgrund seiner hohen Wärmeleitfähigkeit, seines Siedepunkts und seiner dielektrischen Eigenschaften gut als elektrisch nichtleitendes Wärmetransportmedium für die Zweiphasenkühlung geeignet. Durch eine derartige Zweiphasenkühlung wird eine effiziente Entwärmung ermöglicht.

Eine weitere Ausführungsform sieht vor, dass der metallische Körper aus Aluminium, Kupfer oder eine deren Legierungen hergestellt wird. Ein derartiger Werkstoff ist mittels des FSC-Verfahrens gut verarbeitbar. Ferner ist eine gute elektrische und thermische Verbindung herstellbar.

Im Folgenden wird die Erfindung anhand der in den Figuren dargestellten Ausführungsbeispiele näher beschrieben und erläutert.

Es zeigen:
- FIG 1: eine schematische Querschnittsdarstellung eines Verfahrens zum Herstellen einer Kühlvorrichtung,
- FIG 2: eine schematische Querschnittsdarstellung einer ersten Ausführungsform einer Halbleiteranordnung,
- FIG 3: eine schematische Querschnittsdarstellung einer zweiten Ausführungsform einer Halbleiteranordnung,
- FIG 4: eine schematische dreidimensionale Darstellung einer Kühlvorrichtung und
- FIG 5: eine schematische Darstellung eines Stromrichters.

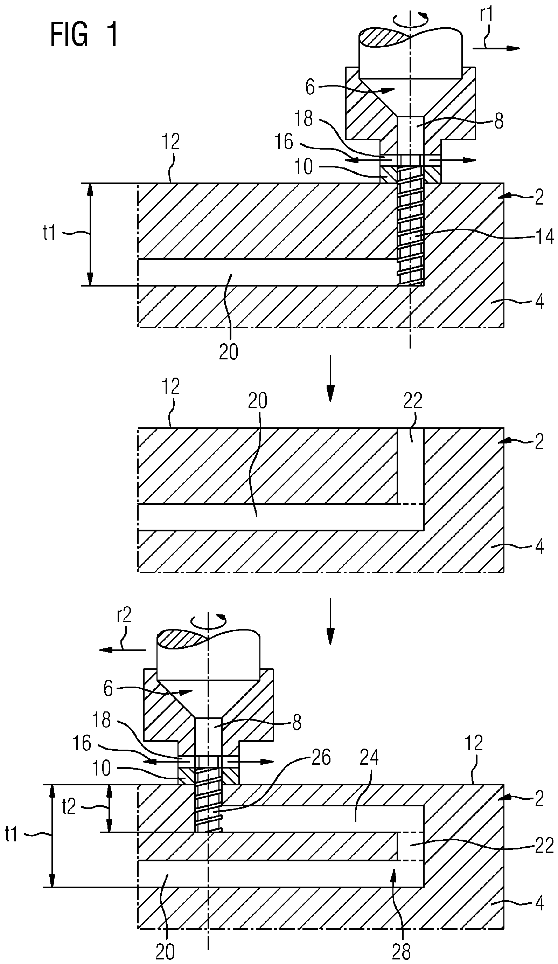

FIG 1 zeigt eine schematische Querschnittsdarstellung eines Verfahrens zum Herstellen einer Kühlvorrichtung 2, welche einen metallischen Körper 4 umfasst. Der metallische Körper 4 kann unter anderem Aluminium, Kupfer oder eine deren Legierungen enthalten. Das Herstellen der Kühlvorrichtung 2 erfolgt mittels eines FSC-Verfahrens. Bei einem derartigen FSC-Verfahren bzw. dem Friction Stir Channelling, auf Deutsch Rührreibkanalisieren genannt, handelt es sich um eine Weiterentwicklung des Rührreibschweißens, bei dem das Rührreibverfahren so modifiziert wird, dass das Material absichtlich aus der Masse des Werkstücks herausbewegt und so ein Kanal ausgebildet wird. Ein Werkzeug 6 mit einer rotierenden Sonde 8 taucht in den metallischen Körper 4 ein und wird in eine erste Bewegungsrichtung r1 verfahren, wobei eine Schulter 10 eine, insbesondere ebene, Oberfläche 12 des metallischen Körpers 4 berührt. Die rotierenden Sonde 8 weist einen gewindeartig profilierten Schweißdorn 14 auf. Durch die Rotationsbewegung des gewindeartig profilierten Schweißdorns 14 wird der metallische Werkstoff des metallischen Körpers 4 plastifiziert. Es erfolgt eine Extrusion 16 eines Teils des plastifizierten Materials, das über zumindest eine Extrusionsöffnung 18 ausgestoßen wird. Diese Materialsubtraktion führt zur Ausbildung des geschlossenen, unter der Oberfläche 12 verlaufenden Kanals.

In einem ersten Schritt wird mittels eines erstens FSC-Verfahrens ein erster Kühlkanal 20 in einer ersten Tiefe t1 im metallischen Körper 4 hergestellt, wobei das Herstellen des ersten Kühlkanals 20 mittels eines Werkzeugs 6 mit einem ersten Schweißdorn 14 erfolgt. Der erste Kühlkanal 20 wird im Wesentlichen parallel zur ebenen Oberfläche 12 des metallischen Körpers 4 angeordnet.

Daraufhin wird mittels des erstens FSC-Verfahrens ein erster Verbindungskanal 22 hergestellt, welcher vom ersten Kühlkanal 20 zur ebenen Oberfläche 12 des metallischen Körpers 4 verlaufenden angeordnet wird. Der erste Verbindungskanal 22 wird im Wesentlichen senkrecht zum ersten Kühlkanal 20 und zur Oberfläche 12 des metallischen Körpers 4 verlaufenden angeordnet.

In einem weiteren Schritt erfolgt das Herstellen eines zweiten Kühlkanals 24 mittels eines zweiten FSC-Verfahrens in einer zweiten Tiefe t2 im metallischen Körper 4, wobei die zweite Tiefe t2 kleiner als die erste Tiefe t1 ist. Der zweite Kühlkanal 24 wird mittels eines Werkzeugs 6 mit einem zweiten Schweißdorn 26 hergestellt, welcher kürzer als der erste Schweißdorn 14 ist und in eine zweite Bewegungsrichtung r2 verfahren wird. Der zweite Kühlkanal 24 wird ebenfalls im Wesentlichen parallel zur ebenen Oberfläche 12 des metallischen Körpers 4 angeordnet. Über den ersten Verbindungskanal 22 wird eine fluidtechnische Verbindung zwischen dem ersten Kühlkanal 20 und dem zweiten Kühlkanal 24 hergestellt, wobei durch die Kühlkanäle 20, 24 und den ersten Verbindungskanal 22 eine Kühlkanalstruktur 28 ausgebildet wird.

Durch die Anwendung von FSC-Verfahren in verschiedene Arbeitstiefen nacheinander auf demselben metallischen Körper 4 sind Kühlkanäle 20, 24 in unterschiedlichen Tiefen t1, t2 herstellbar, sodass eine komplexe Kühlkanalstruktur 28 erstellt werden kann.

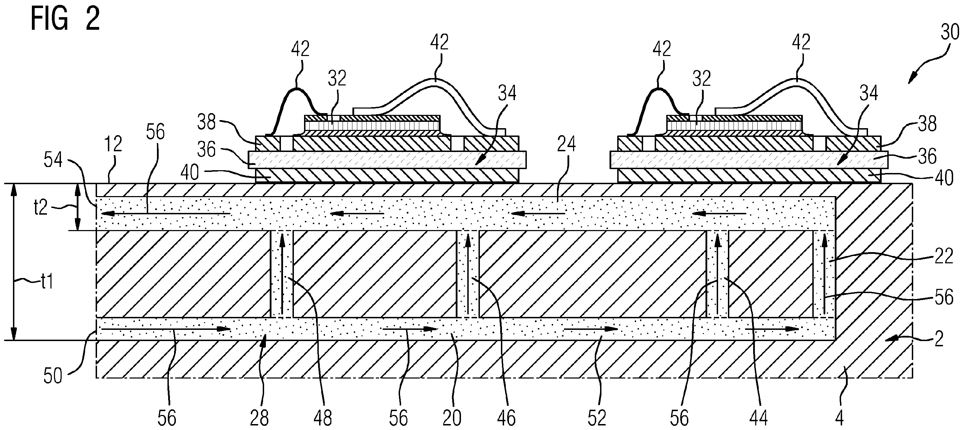

FIG 2 zeigt eine schematische Querschnittsdarstellung einer ersten Ausführungsform einer Halbleiteranordnung 30, welche Halbleiterelemente 32 umfasst. Die Halbleiterelemente 32 sind beispielhaft als vertikale Leistungstransistoren, insbesondere als Insulated-Gate-Bipolar-Transistor (IGBT), ausgeführt und jeweils stoffschlüssig mit einem Substrat 34 verbunden. Beispielsweise sind die IGBTs kollektorseitig mit dem jeweiligen Substrat 34 verbunden. Die stoffschlüssige Verbindung kann unter anderem eine Lötverbindung und/oder eine Sinterverbindung aber auch eine adhäsive Verbindung, z.B. mit einem elektrisch und thermisch leitfähigen Kleber, sein. Die Substrate 34 weisen jeweils eine dielektrische Materiallage 36, eine auf einer dem Halbleiterelement 32 zugewandten Seite angeordnete erste Metallisierung 38 und eine auf einer dem Halbleiterelement 32 abgewandten Seite angeordnete zweite Metallisierung 40 auf. Die dielektrische Materiallage 36 kann unter anderem einen keramischen Werkstoff, beispielsweise Aluminiumnitrid oder Aluminiumoxid, oder einen organischen Werkstoff, beispielsweise ein Polyamid oder Epoxidharz, enthalten. Ferner sind die IGBTs gate- und emitterseitig über Bondverbindungen 42, insbesondere über Bonddrähte oder Bondbänder, mit der ersten Metallisierung 38 des jeweiligen Substrats 34 verbunden. Die zweite Metallisierung 40 des jeweiligen Substrats 34 ist stoffschlüssig, beispielsweise über eine Lötverbindung, mit der Oberfläche 12 der Kühlvorrichtung 2 verbunden. Alternativ kann die zweite Metallisierung 40 des jeweiligen Substrats 34 über Wärmeleitpaste mit der Oberfläche 12 der Kühlvorrichtung 2 verbunden sein. Somit sind die IGBTs elektrisch isolierend und thermisch leitend mit der Kühlvorrichtung 2 verbunden.

Die Kühlvorrichtung 2 weist einen ersten Kühlkanal 20 und einen zweiten Kühlkanal 24 auf, welche durch Verbindungskanäle 22, 44, 46, 48 verbunden sind. Die Kühlkanäle 20, 24 und die Verbindungskanäle 22, 44, 46, 48 sind, wie in FIG 1 beschrieben, mittels FSC-Verfahren hergestellt. Ferner weist der erste Kühlkanal 20 einen ersten Fluidanschluss 50 auf, welcher beispielhaft zur externen Zuführung eines Wärmetransportfluides 52 vorgesehen ist, während der zweite Kühlkanal 24 einen zweiten Fluidanschluss 54 aufweist, welcher beispielhaft zum Abführend des Wärmetransportfluides 52 vorgesehen ist. Ein derartiges Wärmetransportfluid 52 kann elektrisch leitfähig und elektrisch nicht-leitfähig ausgeführt sein. Unter anderem kommen Luft, insbesondere deionisiertes, Wasser, eine Wasser-Glykol-Gemisch, dielektrische Flüssigkeiten und/oder Öle infrage. Somit wird durch den ersten Kühlkanal 20, den zweiten Kühlkanal 24 und die Verbindungskanäle 22, 44, 46, 48 eine offene Kühlkanalstruktur 28. Ein Wärmetransport findet über eine Strömung 56 des Wärmetransportmediums 24 durch die Kühlkanäle 20, 24 und durch die Verbindungskanäle 22, 44, 46, 48 statt. Durch geschickte Anordnung der Kühlkanalstruktur 28 kann zusätzlich zur optimierten Medium-Führung noch der Effekt einer Prallkühlung (impingement cooling) zur lokalen Reduzierung des Wärmeüberganskoeffizienten eingesetzt werden. Die weitere Ausgestaltung der Kühlvorrichtung 2 in FIG 2 entspricht der in FIG 1.

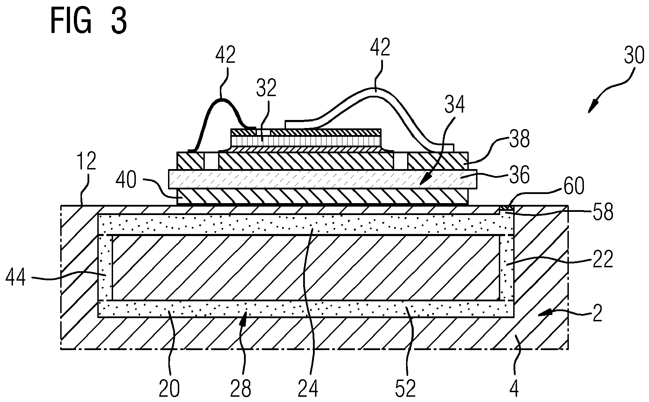

FIG 3 zeigt eine schematische Querschnittsdarstellung einer zweiten Ausführungsform einer Halbleiteranordnung 30, wobei durch einen ersten Kühlkanal 20, einen zweiten Kühlkanal 24 und Verbindungskanäle 22, 44 eine geschlossene Kühlkanalstruktur 28 ausgebildet wird. Zumindest einer der Kühlkanäle 20, 24 ist mäanderförmig verlaufend angeordnet, wobei die Kühlkanalstruktur 28 mit dem Wärmetransportfluid 52 für eine Zweiphasenkühlung konfiguriert ist. Beispielhaft wird in FIG 3 eine pulsierende Heatpipe ausgebildet.

Ein Zuführungskanal 58, welcher mittels des zweiten FSC-Verfahrens hergestellt und vom zweiten Kühlkanal 24 zur Oberfläche 12 des metallischen Körpers 4 verlaufend angeordnet ist, dient zum Befüllen der Kühlkanalstruktur 28 mit dem Wärmetransportfluid 52. Darüber hinaus ist der Zuführungskanal 58 mit einem Verschlusselement 60, z.B. mit einem Abdichtstopfen, fluiddicht und lösbar verschlossen. Die weitere Ausgestaltung der Halbleiteranordnung 30 in FIG 3 entspricht der in FIG 2.

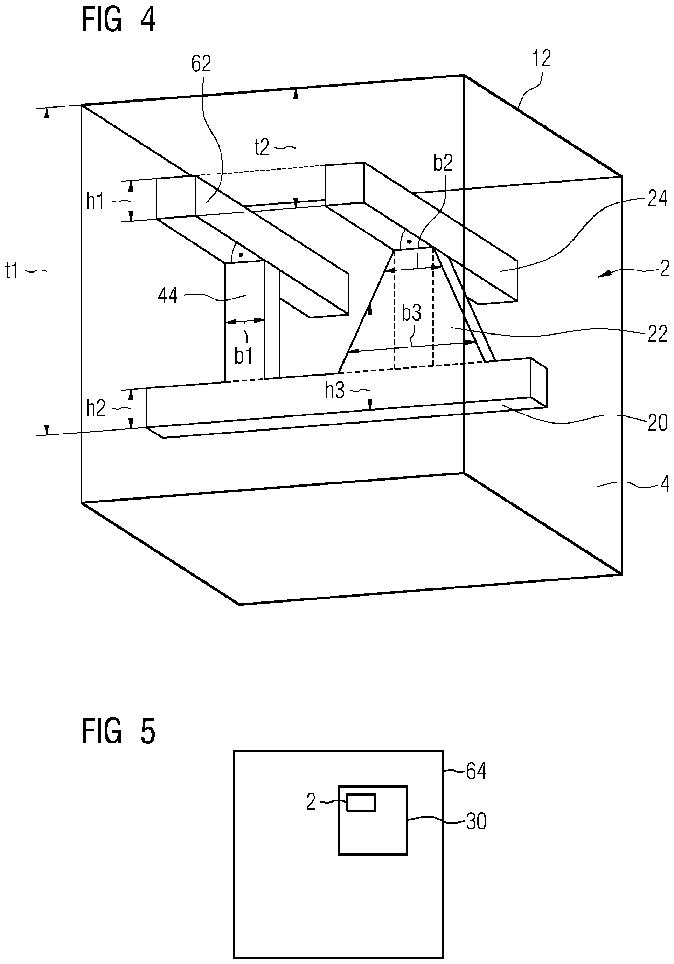

FIG 4 zeigt eine schematische dreidimensionale Darstellung einer Kühlvorrichtung 2, welche einen ersten Kühlkanal 20 aufweist, der in einer ersten Tiefe t1 im metallischen Körper 4 angeordnet und mittels eines ersten FSC-Verfahrens hergestellt ist. Ferner umfasst die Kühlvorrichtung 2 einen ersten Verbindungskanal 22 und einen zweiten Verbindungskanal 44, welche ebenfalls mittels des erstens FSC-Verfahrens hergestellt sind und vom ersten Kühlkanal 20 zur ebenen Oberfläche 12 des metallischen Körpers 4 verlaufend angeordnet sind. Darüber hinaus umfasst die Kühlvorrichtung 2 einen zweiten Kühlkanal 24 und einen parallel zum zweiten Kühlkanal 24 verlaufenden dritten Kühlkanal 62. Beide Kühlkanäle verlaufen jeweils orthogonal zum ersten Kühlkanal 20. Überdies ist der zweite Kühlkanal 24 'über den ersten Verbindungskanal 22 mit dem ersten Kühlkanal 20 verbunden, während der dritte Kühlkanal 62 über den zweiten Verbindungskanal 44 mit dem ersten Kühlkanal 20 verbunden ist.

Das FSC-Verfahren arbeitet mit einem austarierten Prozess. Es wird genau so viel Material herausgefördert, wie für den gewünschten Kanalquerschnitt erforderlich ist. Das Material, dass nicht abgeführt wird, staut sich in Bereich der Schulter 10 (vgl. FIG 1) und erzeugt den verschlossenen Kanal. Die Material-Förderrate ist unter anderem abhängig von der Werkzeuggeometrie, der Drehzahl, der Verfahrgeschwindigkeit und der Plastifizierung des Material. Beim Herstellen der Kühlkanäle 20, 24, 62 mit dem jeweiligen FSC-Verfahren ist somit die Kanalhöhe h1, h2, h3 durch Variieren einer Drehzahl des jeweiligen Werkzeugs 6 und/oder durch Variieren einer Verfahrgeschwindigkeit des jeweiligen Werkzeugs 6 veränderbar. Wenn an einer Stelle mehr Material abtransportiert wird, wird ein Kanal an dieser Stelle höher. Die Veränderung der Prozessparameter kann auch graduell erfolgen, wodurch eine Kontur in der Kanaldecke entsteht.

Während die Kanalhöhe h1 des zweiten Kühlkanals 24 und des dritten Kühlkanals 62 konstant ist, was durch eine konstante Drehzahl und eine konstante Verfahrgeschwindigkeit des Werkzeugs 6 erreichbar ist, weist der erste Kühlkanal 20 im Bereich des ersten Verbindungskanals 22 eine, insbesondere linear, ab- bzw. abfallende Kanalhöhe h2, h3 auf. Eine steigende Kanalhöhe h2, h3 ist z.B. erreichbar durch einen graduellen Abfall der Verfahrgeschwindigkeit und/oder eine Steigerung der Drehzahl des Werkzeugs 6. Eine fallende Kanalhöhe h2, h3 ist z.B. erreichbar durch einen graduellen Anstieg der Verfahrgeschwindigkeit und/oder eine Senkung der Drehzahl des Werkzeugs 6. Durch die Kanalhöhe h2, h3 des ersten Verbindungskanals 20 im Bereich der Verbindungskanäle 22, 44 wird die Kanalbreite b1, b2, b3 des jeweiligen Verbindungskanals 22, 44 beeinflusst. Eine Kanalbreite b2, b3 des ersten Verbindungskanals 22 wird beispielsweise durch einen graduellen Abfall und/oder Anstieg der Verfahrgeschwindigkeit und/oder der Drehzahl des Werkzeugs 6 verändert. Auf diese Weise ist ein derartiger sich verjüngender Verbindungskanal 22, bei welchem die Kanalbreite b2, b3 zur Oberfläche 12 hin, insbesondere monoton, ferner insbesondere linear, abnimmt. Durch Veränderung der Kanalhöhe h1, h2, h3 eines Kühlkanals 20, 24, 62 bzw. Kanalbreite b1, b2, b3 eines Verbindungskanals 22, 44 ist eine verbesserter Wärmetransport z.B. im Bereich von Hotspots erreichbar. Die weitere Ausgestaltung der Kühlvorrichtung 2 in FIG 4 entspricht der in FIG 1.

FIG 9 zeigt eine schematische Darstellung eines Stromrichters 64, welcher beispielhaft eine Halbleiteranordnung 30 umfasst. Die Halbleiteranordnung 30 umfasst beispielhaft eine Kühlvorrichtung 2.

Zusammenfassend betrifft die Erfindung ein Verfahren zum Herstellen einer Vorrichtung 2 zur Kühlung einer Halbleiteranordnung. Um ein kostengünstiges und einfaches Herstellungsverfahren anzugeben, welches eine verbesserte Entwärmung der Halbleiteranordnung ermöglicht, werden folgende Schritte vorgeschlagen: Herstellen eines ersten Kühlkanals 20 mittels eines erstens FSC-Verfahrens in einer ersten Tiefe t1 im metallischen Körper 4, Herstellen eines ersten Verbindungskanals 22 mittels des erstens FSC-Verfahrens, welcher vom ersten Kühlkanal 20 zu einer, insbesondere ebenen, Oberfläche 12 des metallischen Körpers 4 verlaufenden angeordnet wird, Herstellen eines zweiten Kühlkanals 24 mittels eines zweiten FSC-Verfahrens in einer zweiten Tiefe t2 im metallischen Körper 4, wobei die zweite Tiefe t2 kleiner als die erste Tiefe t1 ist, wobei über den ersten Verbindungskanal 22 eine fluidtechnische Verbindung zwischen dem ersten Kühlkanal 20 und dem zweiten Kühlkanal 24 hergestellt wird, wobei durch die Kühlkanäle 20, 24 und den ersten Verbindungskanal 22 eine Kühlkanalstruktur 28 ausgebildet wird.

## Patentansprüche

1. Verfahren zum Herstellen einer Vorrichtung (2) zur Kühlung einer Halbleiteranordnung mit einem metallischen Körper (4) umfassend folgende Schritte:
- Herstellen eines ersten Kühlkanals (20) mittels eines erstens FSC-Verfahrens in einer ersten Tiefe (t1) im metallischen Körper (4),
- Herstellen eines ersten Verbindungskanals (22) mittels des erstens FSC-Verfahrens,
welcher vom ersten Kühlkanal (20) zu einer, insbesondere ebenen, Oberfläche (12) des metallischen Körpers (4) verlaufenden angeordnet wird,
- Herstellen eines zweiten Kühlkanals (24) mittels eines zweiten FSC-Verfahrens in einer zweiten Tiefe (t2) im metallischen Körper (4),
wobei die zweite Tiefe (t2) kleiner als die erste Tiefe (t1) ist,
wobei über den ersten Verbindungskanal (22) eine fluidtechnische Verbindung zwischen dem ersten Kühlkanal (20) und dem zweiten Kühlkanal (24) hergestellt wird,
wobei durch die Kühlkanäle (20, 24) und den ersten Verbindungskanal (22) eine Kühlkanalstruktur (28) ausgebildet wird.

2. Verfahren nach Anspruch 1,
wobei der erste Verbindungskanal (22) im Wesentlichen senkrecht zum ersten Kühlkanal (20) und/oder zur Oberfläche (12) des metallischen Körpers (4) verlaufenden angeordnet wird.

3. Verfahren nach einem der Ansprüche 1 oder 2,
wobei der erste Kühlkanal (20) und/oder der zweite Kühlkanal (24) im Wesentlichen parallel zur Oberfläche (12) des metallischen Körpers (4) angeordnet werden.

4. Verfahren nach einem der vorherigen Ansprüche,
wobei das Herstellen des ersten Kühlkanals (20) mittels eines Werkzeugs (6) mit einem ersten Schweißdorn (14) und
das Herstellen des zweiten Kühlkanals (24) mittels eines Werkzeugs (6) mit einem zweiten Schweißdorn (26) erfolgt, wobei der erste Schweißdorn (14) länger als der zweite Schweißdorn (26) ist.

5. Verfahren nach einem der vorherigen Ansprüche,
wobei eine Kanalhöhe (h1, h2, h3) eines Kühlkanals (20, 24) durch Variieren einer Drehzahl eines Werkzeugs (6) und/oder durch Variieren einer Verfahrgeschwindigkeit eines Werkzeugs (6) verändert wird.

6. Verfahren nach einem der vorherigen Ansprüche,
wobei eine Kanalbreite (b1, b2, b3) des ersten Verbindungskanals (22) durch einen graduellen Abfall und/oder Anstieg einer Drehzahl und/oder Verfahrgeschwindigkeit eines Werkzeugs (6) verändert wird.

7. Verfahren nach einem der vorherigen Ansprüche,
wobei zumindest einer der Kühlkanäle (20, 24) mäanderförmig verlaufend angeordnet wird.

8. Verfahren nach einem der vorherigen Ansprüche umfassend folgende weiteren Schritte:
- Herstellen eines Zuführungskanals (58) mittels des zweiten FSC-Verfahrens, welcher vom zweiten Kühlkanal (24) zu einer Oberfläche (12) des metallischen Körpers (4) verlaufend angeordnet wird
- Befüllen der Kühlkanalstruktur (28) über den Zuführungskanal (58) mit einem Wärmetransportfluid (52) und
- Verschließen des Zuführungskanals (58).

9. Verfahren nach Anspruch 8,
wobei die Kühlkanalstruktur (28) mit dem Wärmetransportfluid (52) für eine Zweiphasenkühlung konfiguriert ist.

10. Verfahren nach einem der vorherigen Ansprüche,
wobei der metallische Körper (4) aus Aluminium, Kupfer oder eine deren Legierungen hergestellt wird.

11. Vorrichtung (2) zur Kühlung einer Halbleiteranordnung umfassend:
- einen metallischen Körper (4)
- einen mittels eines erstens FSC-Verfahrens hergestellten ersten Kühlkanal (20),
welcher in einer ersten Tiefe (t1) im metallischen Körper (4) verlaufend angeordnet ist,
- einen mittels des erstens FSC-Verfahrens hergestellten ersten Verbindungskanal (22),
welcher vom ersten Kühlkanal (20) zu einer, insbesondere ebenen, Oberfläche (12) des metallischen Körpers (4) verlaufenden angeordnet ist,
- einen mittels eines zweiten FSC-Verfahrens hergestellten zweiten Kühlkanal (24),
welcher in einer zweiten Tiefe (t2) im metallischen Körper (4) verlaufend angeordnet ist,
wobei die zweite Tiefe (t2) kleiner als die erste Tiefe (t1) ist,
wobei der erste Kühlkanal (20) mit dem zweiten Kühlkanal (24) über den ersten Verbindungskanal (22) in einer fluidtechnischen Verbindung steht,
wobei durch die Kühlkanäle (20, 24) und den ersten Verbindungskanal (22) eine Kühlkanalstruktur (28) ausgebildet ist.

12. Vorrichtung (2) nach Anspruch 11,
wobei der erste Verbindungskanal (22) im Wesentlichen senkrecht zum ersten Kühlkanal (20) und/oder zur Oberfläche (12) des metallischen Körpers (4) verlaufenden angeordnet ist.

13. Vorrichtung (2) nach einem der Ansprüche 11 oder 12,
wobei der erste Kühlkanal (20) und/oder der zweite Kühlkanal (24) im Wesentlichen parallel zur Oberfläche (12) des metallischen Körpers (4) angeordnet sind.

14. Vorrichtung (2) nach einem der Ansprüche 11 bis 13,
wobei die Kühlkanalstruktur (28) ein Wärmetransportfluid (52) enthält und für eine Zweiphasenkühlung konfiguriert ist.

15. Halbleiteranordnung (30) mit mindestens einem Halbleiterelement (32) und einer Vorrichtung (2) nach einem der Ansprüche 11 bis 14,
wobei das Halbleiterelement (32) mit der Vorrichtung (2) in einer thermisch leitenden Verbindung steht.

16. Stromrichter (64) mit mindestens einer Halbleiteranordnung (30) nach Anspruch 15.
